(19) Europäisches Patentamt
European Patent Office
Office européen des brevets

(11) **EP 1 803 173 B1**

(12) **EUROPÄISCHE PATENTSCHRIFT**

(45) Veröffentlichungstag und Bekanntmachung des Hinweises auf die Patenterteilung:
**07.04.2010 Patentblatt 2010/14**

(51) Int Cl.:
*H01L 51/00* *(2006.01)*    *H01L 51/30* *(2006.01)*

(21) Anmeldenummer: **05795027.1**

(22) Anmeldetag: **21.10.2005**

(86) Internationale Anmeldenummer:
**PCT/EP2005/011362**

(87) Internationale Veröffentlichungsnummer:
**WO 2006/045562 (04.05.2006 Gazette 2006/18)**

(54) **VERFAHREN ZU HERSTELLUNG EINES HALBLEITERBAUELEMENTS UNTER VERWENDUNG VON ANORGANISCH-ORGANISCHEN HYBRIDPOLYMEREN**

METHOD FOR THE PRODUCTION OF A SEMI-CONDUCTOR COMPONENT BY MEANS OF INORGANIC-ORGANIC HYBRID POLYMERS

PROCEDE POUR LA PRODUCTION D'UN DISPOSITIF SEMI-CONDUCTEUR EN UTILISANT DE POLYMERES HYBRIDES ORGANIQUES/INORGANIQUES

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **22.10.2004 DE 102004051616**

(43) Veröffentlichungstag der Anmeldung:
**04.07.2007 Patentblatt 2007/27**

(73) Patentinhaber:
• **Fraunhofer-Gesellschaft zur Förderung der angewandten Forschung e.V.**
**80686 München (DE)**
• **Joanneum Research Forschungsgesellschaft mbH**
**8010 Graz (AT)**

(72) Erfinder:
• **HOUBERTZ-KRAUSS, Ruth**
**97440 Werneck (DE)**
• **SCHMITT, Angelika**
**97080 Würzburg (DE)**
• **DOMANN, Gerhard**
**D-97204 Höchberg (DE)**
• **POPALL, Michael**
**97092 Würzburg (DE)**
• **STADLOBER, Barbara**
**A-8044 Graz (AT)**
• **HAAS, Ursula**
**A-8200 Gleisdorf (AT)**
• **HAASE, Anja**
**A-8010 Graz (AT)**

(74) Vertreter: **Pfenning, Meinig & Partner GbR Patent- und Rechtsanwälte Theresienhöhe 13 80339 München (DE)**

(56) Entgegenhaltungen:
**WO-A-03/031499**

• **HOUBERTZ R ET AL: "Inorganic-organic hybrid materials for polymer electronic applications" MATER RES SOC SYMP PROC; MATERIALS RESEARCH SOCIETY SYMPOSIUM - PROCEEDINGS 2003, Bd. 769, 21. April 2003 (2003-04-21), - 25. April 2003 (2003-04-25) Seiten 239-244, XP002359939**
• **HOUBERTZ R ET AL: "Inorganic-organic hybrid materials (ORMOCER(R)s) for multilayer technology-passivation and dielectric behavior" ELECTRONIC, OPTICAL AND OPTOELECTRONIC POLYMERS AND OLIGOMERS. SYMPOSIUM (MATER. RES. SOC. SYMPOSIUM PROCEEDINGS VOL.665) MATER. RES. SOC WARRENDALE, PA, USA, 2001, Seiten 321-326, XP002359940 ISBN: 1-55899-601-X**
• **POPALL M ET AL: "ORMOCER(R)s-inorganic-organic hybrid materials for e/o-interconnection-technology" MOLECULAR CRYSTALS AND LIQUID CRYSTALS GORDON & BREACH SWITZERLAND, Bd. 354, 2000, Seiten 711-730, XP008057603 ISSN: 1058-725X**

- HAAS U ET AL: "Growth process control of pentacene thin films and its application in full organic thin film transistors" POLYMERS AND ADHESIVES IN MICROELECTRONICS AND PHOTONICS, 2004. POLYTRONIC 2004. 4TH IEEE INTERNATIONAL CONFERENCE ON PORTLAND, OR, USA 12-15 SEPT. 2004, PISCATAWAY, NJ, USA,IEEE, 12. September 2004 (2004-09-12), Seiten 219-224, XP010775950 ISBN: 0-7803-8744-9
- DABEK A ET AL: "EVALUATION OF ORMOCERS FOR MICROELECTRONICS APPLICATIONS" EUROPEAN MICROELECTRONICS CONFERENCE, 1997, Seiten 125-132, XP009026117
- ROBERTSSON M E ET AL: "O/e-MCM packaging with new, patternable dielectric and optical materials" ELECTRONIC COMPONENTS & TECHNOLOGY CONFERENCE, 1998. 48TH IEEE SEATTLE, WA, USA 25-28 MAY 1998, NEW YORK, NY, USA,IEEE, US, 25. Mai 1998 (1998-05-25), Seiten 1413-1421, XP010283789 ISBN: 0-7803-4526-6
- FROHLICH L ET AL: "Inorganic-organic hybrid polymers as photo-patternable dielectrics for multilayer microwave circuits" ORGANIC/ INORGANIC HYBRID MATERIALS - 2002. SYMPOSIUM (MATERIALS RESEARCH SOCIETY SYMPOSIUM PROCEEDINGS VOL.726) MATER. RES. SOC WARRENDALE, PA, USA, 2002, Seiten 349-354, XP002359941

**Beschreibung**

Die Erfindung betrifft ein Halbleiterbauelement mit einer Metall-Isolator-Struktur (MIS), das als Grundbestandteile ein Substrat, eine Schicht aus einem organischen Halbleitermaterial und eine dielektrische Schicht als Isolator enthält. Von diesen Grundbestandteilen wird das Substrat und/oder die dielektrische Schicht aus einem anorganisch-organischen Hybridpolymer gewählt. Weiterhin betrifft die Erfindung ein Verfahren zur Herstellung derartiger Halbleiterbauelemente sowie die Verwendung von anorganisch-organischen Hybridpolymeren zur Herstellung von Halbleiterbauelementen.

Da die konventionelle Mikroelektronikindustrie an einem Punkt angelangt ist, an dem die von der Dynamik des Informationstechnologiemarktes motivierte stetige Steigerung der Integrationsdichte immer komplexere Technologien erfordert und damit exponentiell steigende Produktionskosten mit sich bringt, wird Elektronik, die auf kostengünstigen organischen und synthetischen Werkstoffen basiert immer dort wichtiger, wo eine direkte Integration von Elektronik auf Verbrauchs- und Konsumgütern gefordert ist. Kostenreduktion ist allerdings nicht die einzige Marktstrategie im Bereich der Polymerelektronik. So könnten mit diesen flexiblen und teils biokompatiblen Materialien, Elektronik-, Optik- und Sensorkomponenten in einer Weise kombiniert werden, die mit Silizium gar nicht oder nur unter erheblichem Kostenaufwand möglich ist.

Nach wie vor liegt die Performance der organischen Bauelementen weit unter derjenigen von Silizium. Selbst im besten organischen Halbleiter Pentazen ist der höchste bislang berichtete Wert für die Ladungsträgerbeweglichkeit immer noch drei Größenordnungen unter dem für Silizium.

Abgesehen von diesen physikalischen Beschränkungen gab es im letzten Jahrzehnt beeindruckende Verbesserungen in der Performance organischer Bauelemente, die einen Einsatz organischer Elektronik in einer Reihe von kostengünstigen, großflächigen Anwendungen mittelfristig immer wahrscheinlicher machen, wie beispielsweise aktiv gesteuerte Flachbildschirme, Smartkarten, elektronisches Papier, RF-ID Etiketten und großflächige Sensoren.

Neben dem naheliegenden Kostenargument hat organische Elektronik gegenüber Anorganischer vor allem den Vorteil der niedrigen Prozesstemperaturen ($\leq 200°C$), wodurch elektronische Schaltkreise auf großflächigen, billigen, flexiblen, leichten, haltbaren und sogar biologischen Substraten integriert werden können, was natürlich ein weites Feld an neuen Anwendungen eröffnet. Dadurch können elektronische Schaltkreise erstmals auf allen Materialien des täglichen Lebens integriert werden ("ambient intelligence") und damit die Vision eines elektronisch gestützten Alltags Realität werden lassen. Beispiel für solche visionären Produkte sind am Körper integrierte intelligente Farb- und Temperatursensoren, elektronisches Wandpapier und rollbare Displays. Langfristig wird die Produktion einfacher organischer elektronischer Komponenten in kostengünstigen Rolle-zu-Rolle- oder Blattzu-Blatt-Verfahren durchgeführt werden.

Das Basiselement organischer Elektronik ist der organische Feldeffekttransistor. Wie bereits erwähnt, ist der aromatische, kleinmolekulare Kohlenwasserstoff Pentazen ein herausragender Kandidat für den aktiven Halbleiter, da er hochgeordnete, polykristalline, dünne Filme (Stadlober, V. Satzinger, H. Maresch, D. Somitsch, A. Haase, H. Pichler, W. Rom und G. Jakopic (2003), Structural and Electrical Properties of Polymorphic Pentacene Thin Films. Proceedings of SPIE, Vol. 5217, Organic Field Effect Transistors II, ed. C.C: Dimitrakopoulos und A. Dodabalapur (SPIE, Bellingham, WA, 2003) bildet, die höchste Ladungsträgerbeweglichkeit aller organischen Halbleiter aufweist und in Atmosphäre wesentlich stabiler als die meisten Polymerhalbleiter, wie beispielsweise Polythiophen, ist. Während der letzten fünf Jahre lag die Verbesserung der elektrischen Charakteristik von auf Pentazen basierenden Feldeffekttransistoren im Zentrum des Interesses einer Vielzahl von Polymerphysik/-chemie-Gruppen. Viel Energie wurde in die Optimierung des Herstellungsprozesses und des Designs, in die Verbesserung herkömmlicher anorganischer, in die Variation organischer Dielektrika, in die Optimierung der Grenzflächen und der Kontaktcharakteristik gesteckt. Darüber hinaus steigt das Interesse am Verständnis und der exakten Kontrolle des Wachstumsprozesses der aktiven Halbleiterschicht.

Anorganische Dielektrika wie zum Beispiel $SiO_2$ oder $SiN_x$ und $Al_2O_3$ liefern Pentazen-OFETs mit vernünftigen und sehr reproduzierbaren Kennlinien, obwohl beim Herstellungsprozess oft wesentlich höhere Temperaturen verwendet werden als für organische Elektronik auf flexiblen Substraten notwendig ist. Im Falle von organischen Gatedielektrika gibt es einige vielversprechende Kandidaten. Die Qualität der meisten dieser Schichten ist jedoch sehr schwankend, was auf lokale Variationen in der Schichtdicke und der dielektrischen Konstanten, in der Existenz mobiler Ionen, der großen Anzahl an Einfangstellen (Traps), der Formierung von Dipolen an der Grenzfläche, der geringen Stabilität gegenüber hohen elektrischen Feldern, der hohen Leckströme und der niedrigen Resistenz gegenüber Chemikalien, die in photolithographischen Prozessen verwendet werden, zurückzuführen ist. Für eine Skalierung der Technologie zu kleineren Dimensionen wäre außerdem die Existenz einer ultradünnen (<200nm), zuverlässigen, organischen Isolationsschicht unausweichlich. Eine weitere Eigenschaft, die für eine Senkung der Produktionskosten und eine Aufrechterhaltung der Qualität der dielektrischen Grenzfläche von Vorteil wäre, liegt in der direkten Strukturierbarkeit der dielektrischen Schicht, um Kontaktlöcher bauen zu können.

Sehr wenig Aufmerksamkeit wurde bisher dem Wechselspiel zwischen Pentazen und dem darunter liegenden Dielektrikum geschenkt (U. Haas et al., Polytronic, 2004, 219-223), obwohl die Grenzfläche zwischen polykristallinem Halbleiter und amorphem Dielektrikum entscheidend für den Ladungsträgertransport (Beweglichkeit) und die Formierung von Traps und Dipolen ist. Für organische Dielektrika gibt es keine systematische Untersuchung der Bedingungen für ein perfektes Engineering dieser Grenzfläche.

Das Filmwachstum eines Oligomer-Halbleiters, wie z.B. Pentazen, aus der Dampfphase wird durch viele Parameter beeinflusst. Abgesehen von der Aufdampfrate und der Substrattemperatur spielen noch das Material des Substrates, seine Rauhigkeit, seine Oberflächenchemie, die Sauberkeit und die Vorbehandlung eine Rolle. Es konnte gezeigt werden, dass das Wachstum von Pentazen auf wohlgeordneten und vorbehandelten Si-Oberflächen durch einen DLA (diffusion-limited aggregation)-Prozess und auf $O_2$-Plasma gereinigten $SiO_2$-Oberflächen durch auf thermodynamischen Ratengleichungen basierender Standard-Nukleationstheorie beschrieben werden kann. Das bedeutet, dass in Abhängigkeit von den Wachstumsbedingungen und der Qualität des Substrates die Nukleation von Pentazeninseln einem vordefinierten und korrelierten Ablauf folgt. Hoch geordnete, polykristalline Pentazenfilme mit großen dentritischen Körnern und wenigen, den Transport behindernden Korngrenzen benötigen äußerst geringe Aufdampfraten, leicht erhöhte Substrattemperaturen und ein sehr glattes dielektrisches Substrat mit einer verschwindenden Anzahl reaktiver Bindungen. Die Wahl des Substratmaterials beeinflusst allerdings nicht nur die Morphologie und Homogenität der Filme und die Korngrößen, sondern auch die Bildung unterschiedlicher Pentazenphasen (Polymorphe). Wenn die Moleküle an der Oberfläche ankommen, ordnen sie sich im Idealfall nahezu senkrecht zur Substratoberfläche und parallel zueinander an. Für eine solche Anordnung ist die Überlappung der $\pi$-Elektronenorbitale maximal und es wird angenommen, dass die Ladungsträgerbeweglichkeiten für den Transport parallel zur Oberfläche am höchsten sind. Abhängig vom Substratmaterial, von der Temperatur und von der Filmdicke bilden sich jedoch vier verschiedene Phasen, die sich nur im Winkel unterscheiden, den die Molekülachse mit der Substratoberfläche bildet. Von einem geometrischen Standpunkt aus betrachtet, ergeben sich dadurch kleine Unterschiede in der Überlappung der $\pi$-Elektronenorbitale. Die Phase mit dem größten Überlapp wird Dünnfilmphase genannt und ist gleichzeitig diejenige mit dem kleinsten Winkel der Molekülachse zur Normalen. Ihre c-Achsenlänge ist 15.5Å. Die zweite Phase, die in polykristallinen Filmen häufig beobachtet wird, ist die Volumenphase, die eine c-Achsenlänge von 14.5Å aufweist. Die beiden restlichen Phasen sind die einkristalline Phase, die nur in ultradicken Filmen oder in Einkristallen beobachtet wird, und eine Phase, die auf wenig gebräuchlichen Substraten (z.B. Kapton) zu finden ist. Wegen der kleinen Unterschiede im Orbitalüberlapp werden kleine Unterschiede in den Transporteigenschaften erwartet. So wird angenommen, dass die Volumenphase mit ihrem größeren Winkel zur Oberfläche und damit kleinerem Orbitalüberlapp auch eine geringere intrinsische Ladungsträgerbeweglichkeit aufweist.

Bisher wurden einige organische OFETs unter Verwendung verschiedenster organischer und anorganischer dielektrischer Materialien beschrieben. Die WO 03/038921 A1 beschreibt einen Isolator für ein organisches Feldeffektbauteil, wie z.B. einen organischen Feldeffekt-Transistor (OFET) und/oder einen organischen Kondensator. Dabei werden im Wesentlichen organische Co-Polymere und deren Mischungen sowie in unpolaren Kohlenwasserstoffen lösliche Basispolymere verwendet. In der WO 02/065557 A1 ist der Aufbau eines solchen OFETs unter anderem unter Verwendung der in der WO 03/038921 A1 beschriebenen Isolatormaterialien beschrieben. Die EP 0 537 240 B1 beschreibt einen Dünnschicht-Transistor mit MIS-Struktur, in dem Halbleiter und Isolator organische Materialien sind. Die Isolatorschicht hat mindestens eine Permittivität von 6, und ist entweder ein Polyvinylalkohol oder ein Cyanoethylpullulan. Weiterhin wird in J.A. Rogers, Z. Bao, und A. Dodabalapur, Organic smart pixels and complementary inverter circuits formed on plastic substrates by casting and rubber stamping, IEEE Electron device lett., Vol. 21, No. 3, 2000 die Verwendung von Polyimid als organisches Dielektrikum zur Herstellung einer organischen Leuchtdiode oder monolithisch integrierter Transistoren beschrieben. In US 6,617,609 B2 wird eine Siloxan-Polymerschicht beschrieben, die als Zwischenschicht auf einem Gate-Dielektrikum und dem organischen Halbleiter eingesetzt wird sowie die Herstellung eines organischen Dünnschicht-Transistors (OTFT) unter Verwendung einer solchen Zwischenschicht. Die US 6,187,427 beschreibt ein Drei-Phasen-Komposit, nämlich anorganische Partikel von weniger als 1$\mu$m Durchmesser in einer organischen, porösen Matrix, das als Zwischenschicht-Dielektrikum für die Herstellung für integrierte Schaltungen (ICs) verwendet wird. Die Poren dienen dabei zur Reduktion der Permittivität auf Werte von $\varepsilon r < 3$ (bei $\geq$ 1 MHz).

Aufgabe der vorliegenden Erfindung war es daher, Halbleiterbauelemente bereitzustellen, die einfach herzustellen sind und die beschriebenen Nachteile des Standes der Technik überwinden.

Diese Aufgabe wird durch das Halbleiterbauelement mit den Merkmalen des Anspruchs 1, das Verfahren zu dessen Herstellung mit den Merkmalen des Anspruchs 17 und die Verwendung von anorganisch-organischen Hybridpolymeren zur Herstellung von Halbleiterbauelementen gemäß Anspruch 19 gelöst. Die weiteren abhängigen Ansprüche zeigen vorteilhafte Weiterbildungen auf.

Erfindungsgemäß wird ein Halbleiterbauelement mit einer Metall-Isolator-Struktur (MIS) bereitgestellt, das ein Substrat, eine Schicht aus einem organischen Halbleitermaterial und eine dielektrische Schicht als Isolator enthält. Die Erfindung zeichnet sich dadurch aus, dass das Substrat und/oder das Dielektrikum aus einem anorganisch-organischen Hybridpolymer besteht.

Anorganisch-organische Hybridpolymere, wie z.B. die am Fraunhofer-ISC entwickelten Ormocere, können hinsichtlich ihrer Materialeigenschaften verschiedenen Anwendungen angepasst werden. Aus der WO 93/25605 und der EP 0 644 908 sind silicon-basierende Lacke, hergestellt mittels Sol-Gel-Prozessierung, und deren Verwendung als Substratbeschichtungen bekannt. Die dort beschriebenen Materialien eignen sich dabei besonders im Einsatz unter sehr rauen Umgebungsbedingungen, also insbesondere als Passivierungs- und Verkapselungsmaterialien gegen Feuchte. Im Bereich der Passivierung von (mikro-)elektronischen Bauelementen, wie z.B. SMT (surface-mount technology)-Bauelementen oder als strukturierte Schicht in Mehrfachschichtaufbauten, wurden Hybridpolymere ausschließlich als abschließende Verkapselungsschicht (strukturierbare Barriereschichten gegen Wasserdampf/Feuchte) eingesetzt. Die Wasserdampfpermeationsraten (WVTR) der Hybridpolymere lassen sich über den Gehalt an anorganischem Anteil sowie den organischen Funktionalitäten steuern. Mit passivierenden, strukturierbaren Hybridpolymeren wurden für diese schon WVTR-Werte von ca. 1,3 $g/m^2d$ (bezogen auf 100 $\mu m$ Schichtdicke) erreicht. Die Durchschlagfestigkeiten (DC) dieser Hybridpolymere liegen im Bereich von 100 bis 300 $V/\mu m$.

Obwohl diese Materialien schon eine hohe Durchschlagfestigkeit gezeigt haben, ihre Permittivitäten bisher im Bereich von 3 bis 4 liegen und sich gute Barriereeigenschaften gegen Feuchte erreichen lassen, werden z.B. für mikroelektronische, nanoelektronische oder polymerelektronische Anwendungen Materialien mit sehr hoher ($\varepsilon_r > 4$) oder sehr niedriger Permittivität ($\varepsilon_r < 3$) über einen weiten Frequenzbereich benötigt, die gleichzeitig mit einer Vielzahl von technologischen Verfahren und in Schichtdicken von deutlich unter 1 $\mu m$, bevorzugt im Bereich von 100 nm oder weniger, pinhole-frei aufgebracht werden können. Darüber hinaus ist insbesondere für die Polymerelektronik eine Eignung als Gate-Dielektrikum und Substrat für organische Halbleiter oder kleine Moleküle wünschenswert, da dadurch Prozessschritte, wie z.B. das vollständige Prozessieren einer Zwischenschicht, entfallen würden. Hierdurch können die Prozessierungszeiten herabgesetzt als auch die Kosten weiter reduziert werden.

Die Kombination eines organisch- anorganischen Hybridmaterials als Gate-Dielektrikum mit einer aktiven polykristallinen halbleitenden Schicht bildet den zentralen Kern einer MIS-Struktur oder eines organischen Dünnschichtkondensators und ist außerordentlich. Die Eigenschaften der halbleitenden Schicht können durch die Änderung der Zusammensetzung, der Synthese und der Prozessierung des anorganisch-organischen passivierenden, strukturierbaren Dielektrikums und damit durch die Qualität des Interfaces gezielt eingestellt werden.

Die chemische Beständigkeit des Gate-Dielektrikums und Substrates gegen kurzes reaktives Ätzen (Gasphase, z.B. $O_2$), Alkohole, Ketone, Acetate oder andere weit verbreitete Chemikalien für die Strukturierung in der Halbleiterindustrie (z.B. UV-Lithographie) ist hervorragend und im Vergleich mit organischen Dielektrika, wie sie z.B. in der Polymerelektronik eingesetzt werden, konkurrenzlos. Dadurch wird auch die Qualität des Interfaces während des gesamten Prozesses erhalten und notwendige Schritte zum Schutz des Dielektrikums während der Prozessierung entfallen. Somit führt dies auch zu einer Kostensenkung. Gleichzeitig kann das Material als strukturierbare Passivierung gegen Umwelteinflüsse verwendet werden, wodurch eine Vielzahl an Anwendungen und Bauelementen möglich werden. Die funktionelle Kombination eines anorganisch-organischen dielektrischen und passivierenden Materials mit einem organisch halbleitenden Material innerhalb eines hochqualitativen organischen Dünnschicht-Transistors liefert einen vielversprechenden Kandidaten für logische Bauelemente für die kostengünstige organische Elektronik.

Das Substrat als auch die dielektrische Schicht sind aus dem anorganisch-organischen Hybridpolymer gebildet. Das Substrat und/oder die dielektrische Schicht können dabei eine Schichtdicke von bevorzugt 1 nm bis 1 $\mu m$ und besonders bevorzugt von 1 nm bis 100 nm aufweisen.

Das Halbleiterbauelement gemäß dem erfindungsgemäßen Verfahren kann vorzugsweise zusätzlich eine Trägerstruktur aufweisen, auf der das Substrat als Schicht abgeschieden ist.

Die Trägerstruktur kann dabei ebenso aus einem anorganisch-organischen Hybridpolymer gebildet sein. Es ist aber auch möglich, dass die Trägerstruktur aus der Gruppe bestehend aus Metallen, Halbleitern, Substraten-mit oxidischen Oberflächen, Gläsern, Folien, printed circuit boards (PCB) Polymeren Heterostrukturen, Papier, Textilien und/oder Verbunden ausgewählt ist.

Das anorganisch-organische Hybridpolymer ist durch ein Verfahren mit den folgenden Schritten erhältlich:

(i) Vorkondensation von:

a) 1 bis 10 Mol-% von mindestens einer SiliciumVerbindung der Formel I:

$$MR_4 \qquad (I)$$

wobei
M ausgewählt ist aus der Gruppe Silicium, Zirkonium, Aluminium und Titan und R ein Halogen, Hydroxy, Alkoxy, Acyloxy oder ein Chelatligand ist;

b) 20 bis 94 Mol-% von mindestens einem organischen Silan der Formel II:

$$R''_m(YR''')_nSi X_{(4-m-n)} \qquad (II)$$

wobei

R"      Alkyl, Aryl, Alkylaryl, Arylalkyl ist,

R'''     Alkylen, Alkenylen, Arylen, Alkylarylen, Arylalkylen, Alkenylarylen, Arylakenylen ist,

wobei R" und R''' durch Sauerstoff, Schwefel oder -NH- unterbrochen sein können,

X      Wasserstoff, Halogen, Hydroxy, Alkoxy, Acyloxy, -NR$_2$' ist, wobei R' gleich H oder Alkyl ist,
Y      eine polymerisierbare Gruppe ist,
m      eine ganze Zahl von 0 bis 2 ist,
n      eine ganze Zahl von 1 bis 3 ist,
m+n    von 1 bis 3 reichen und

c) 5 bis 30 Mol-% von mindestens einem organischen Silan der Formel III:

R"$_p$SiX$_{4-p}$ (III)
wobei R' und X die obige Bedeutung besitzen und p gleich 1, 2 oder 3 ist, und gegebenenfalls

d) 0 bis 10 Mol-% von mindestens einem niedrigflüchtigen im Reaktionsmedium löslichen Metalloxid eines Elementes der Gruppen Ia bis Va oder Vb oder einer im Reaktionsmedium löslichen Verbindung von einem dieser Elemente, welche ein niedrigflüchtiges Oxid bilden;
ohne externe Zugabe von Wasser, gegebenenfalls in Gegenwart eines organischen Lösungsmittels bei einer Temperatur zwischen 0 und 90 °C während eines Zeitraumes zwischen 0,5 und 48 Stunden und

(ii) Hydrolysekondensation des Vorkondensats aus Schritt (i) mit der stöchiometrischen Menge an Wasser, bei einer Temperatur zwischen 0 und 100 °C während eines Zeitraums zwischen 1 und 72 Stunden.

Für mikroelektronische, nanoelektronische oder polymerelektronische Anwendungen sind Materialien mit sehr hoher bzw. sehr niedriger Permittivität über einen weiten Frequenzbereich erforderlich. Vorzugsweise weist das anorganisch-organische Hybridpolymer daher eine Permittivität von $\varepsilon_r$ < 3 auf. In einer weiteren Ausführungsform weist das anorganisch-organische Hybridpolymer vorzugsweise eine Permittivität von $\varepsilon_r$ > 4 auf.
Die Wasserdampfpermeationsraten (WVTR) der Hybridpolymere lassen sich über den Gehalt an anorganischem Anteil sowie den organischen Funktionalitäten steuern. Bevorzugt weist das anorganisch-organische Hybridpolymer eine Wasserdampfpermeationsrate (WVTR) von $10^{-3}$ bis 30 g/m$^2$d, besonders bevorzugt von 0,1 bis 3 g/m$^2$d auf. Diese Raten beziehen sich jeweils auf eine Schichtdicke von 100 $\mu$m.
Das anorganisch-organische Hybridpolymer besitzt vorzugsweise eine Durchschlagsfestigkeit im Bereich von 50 bis 400 V/$\mu$m.
Zudem ist das anorganisch-organische Hybridpolymer vorzugsweise halogenfrei und transparent. Ebenso ist es bevorzugt, dass es gegenüber den in der Halbleiterelektronik verwendeten Chemikalien und Lösungsmitteln beständig ist.
Das Halbleiterbauelement kann vorzugsweise auch eine Source-, eine Drain- sowie eine Gate-Elektrode aufweisen.
Das für das Halbleiterbauelement verwendete organische Halbleitermaterial ist beliebig wählbar, d.h. sämtliche im Stand der Technik bekannten organischen Halbleitermaterialien können eingesetzt werden. Hierzu zählen z.B. Pentazen, Poly(3-hexylthiophen)(P3HT), Poly(p-phenylenvinylen) (PPV), Polyamid (PA), Polyacrylamid (PAA) und Phthalocyanine.
Die erfindungsgemäßen Halbleiterbauelemente werden nach den aus dem Stand der Technik bekannten Verfahrensschritten hergestellt, wobei die Aufbringung der anorganisch-organischen Hybridpolymere durch flächige Auftragungsverfahren, hier insbesondere Spin-Coating, Dip-Coating, Rakeln oder Sprühen, aber auch durch strukturierende Auftragungsverfahren, hier insbesondere Siebdruck, Tampondruck, Ink-Jet, Offset-Druck sowie Tief- und Hochdruck erfolgt.
Erfindungsgemäß wird ebenso die Verwendung von anorganisch-organischen Hybridpolymeren bei der Herstellung von Halbleiterbauelementen bereitgestellt. Dies bezieht sich sowohl auf die Verwendung der anorganisch-organischen Hybridpolymere als Substrate für das kristalline Wachstum kleiner Moleküle (small molecules). Ebenso ist hiervon aber auch die Verwendung als Substrat für das geordnete Aufbringen organischer Halbleiterschichten umfasst. Ein weiteres Anwendungsfeld betrifft die Verwendung der genannten Hybridpolymere als dielektrische Schicht.
Anhand der nachfolgenden Figuren und Beispiele soll der erfindungsgemäße Gegenstand detaillierter erläutert werden, ohne diesen auf die hier gezeigten Ausführungsformen zu beschränken.

Fig. 1 zeigt drei beispielhafte Ausführungsformen erfindungsgemäßer Halbleiterbauelemente.

Fig. 2 zeigt eine Rasterkraftmikroskopaufnahme von der Oberfläche des organischen Halbleiters Pentazen bei einem erfindungsgemäßen Halbleiterbauelement gemäß Beispiel 1.

Fig. 3 zeigt ein Pulverspektrum einer 50 nm-Pentazenschicht gemäß dem erfindungsgemäßen Halbleiterbauelement von Beispiel 1.

Fig. 4 zeigt eine Ausgangskennlinie eines Top-Contact-Halbleiterbauelementes gemäß Beispiel 1.

Fig. 5 zeigt eine Transferkennlinie eines Top-Contact-Halbleiterbauelementes gemäß Beispiel 1. Die Steigung der Geraden entspricht hier dem Subtreshold Slope nach Auffüllung von Grenzflächentraps.

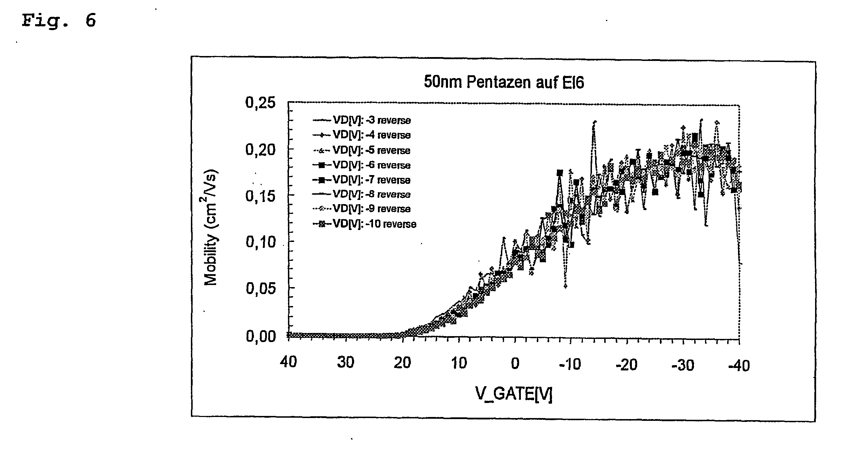

Fig. 6 stellt ein Diagramm dar, das die Gatespannungsabhängigkeit der Ladungsträgerbeweglichkeit eines Top-Contact-Halbleiterbauelementes gemäß Beispiel 1 darstellt.

Fig. 7 zeigt eine Rasterkraftmikroskopaufnahme von dem Halbleiterbauelement gemäß Beispiel 2, wobei die Oberfläche des organischen Halbleiters Pentazen dargestellt ist.

Fig. 8 zeigt ein Pulverspektrum einer 50 nm-Pentazenschicht eines Halbleiterbauelementes gemäß Beispiel 2.

Fig. 9 zeigt in einer graphischen Darstellung die Ausgangskennlinie eines Top-Contact-Halbleiterbauelementes gemäß Beispiel 2.

Fig. 10 zeigt in einem Diagramm die Gatespannungsabhängigkeit der Ladungsträgerbeweglichkeit eines Top-Contact-Halbleiterbauelementes gemäß Beispiel 2.

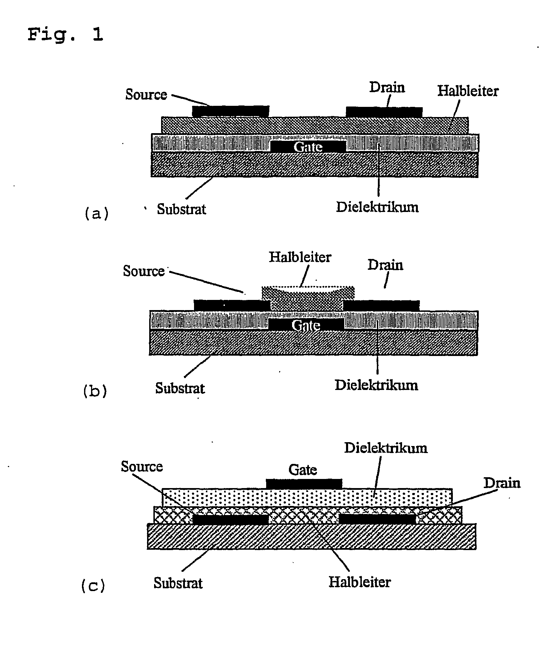

Fig. 1 zeigt typische Schichtfolgen für verschiedene Ausführungsformen der erfindungsgemäßen Halbleiterbauelemente. So zeigt Fig. 1a eine Source- und Drain-Elektrode auf der Halbleiterschicht, sog. Top-Contact, Fig. 1b die Anordnung der Source- und Drain-Elektrode unter dem Halbleiter, sog. Bottom-Contact, und Fig. 1c die sog. Top-Gate-Geometrie, bei der die Source- und Drain-Elektrode unter dem Halbleiter angeordnet sind, während sich die Gate-Elektrode auf dem darüber angeordneten Dielektrikum befindet.

Für Top- und Bottom-Contact wird der Halbleiter direkt auf das anorganisch-organische, dielektrische, passivierende, strukturierbare Hybridpolymer aufgebracht. Um ein wohldefiniertes Interface zu bilden, muss das Oligomerwachstum z.B. im Falle kleiner Moleküle sehr genau eingestellt werden. Dünnschichttransistoren, die auf Oligomeren oder Polymeren basieren, arbeiten in Akkumulation. Das bedeutet, dass die Majoritätsladungsträger, die von der Source-Elektrode injiziert werden, durch eine geeignete Vorspannung zum Interface transportiert werden. Es konnte gezeigt werden, dass die Dicke der Akkumulationsschicht nur 1 bis 2 Oligomer-Monolagen beträgt. Daher ist die Qualität der Grenzfläche für einen ungehinderten Transport der Ladungsträger und daraus resultierend einer hohen Funktionsfähigkeit (hohe Ladungsträger-Mobilität, niedrige Schwellspannung, hohes On/Off-Verhältnis, keine Hysterese des TFT) äußerst wichtig.

**Beispiel 1**

1.1 Harzsynthese und Charakteristika

Die Herstellung von Hybridpolymersystem 1 (EL6) wird für eine 0,4 mol Formulierung beschrieben:

| | |
|---|---|
| 38,6 mol% | GLYMO(3-glycidyloxypropyltrimethoxysilan (Union Carbide)); |
| 38,6 mol% | MEMO (3-methacryloxypropyltrimethoxysilan (Fluka)); |
| 18,92 mol% | Diphenylsilandiol (Fluka); |
| 3,86 mol% | $Zr(opr)_4$ (Zr (tetraisopropoxypropyltrimethoxysilan) (Fluka)); |
| 25 %stöch. | $H_2O$ |

In einen 500 ml Drei-Hals-Kolben, der mit einem Intensivkühler, einem Thermometer und einem Tropfentrichter ausgestattet ist, werden die einzelnen Monomere in oben stehender Reihenfolge eingewogen. Die Suspension wird magnetisch gerührt und die Temperatur um etwa 1 bis 2 °C abgesenkt. Das Rühren bei Raumtemperatur wird nach 18 h beendet und die Temperatur im Verlauf von ungefähr 90 min auf 70°C erhöht. Die Zusammensetzung wird klar und das gesamte Wasser wird der Mischung in einem Schritt zugefügt. Die Temperatur der Mischung wird bei 70°C gehalten. Wenn der Lack nach der Zugabe von Wasser klar wird (nach ca. 20-30 min), wird die Mischung eine weitere Stunde bei gleichbleibend hoher Temperatur gerührt. Nachdem die Reaktion beendet ist, wird der Lack auf Raumtemperatur abgekühlt.

1.2 Substratherstellung (Technologie) und Charakteristika

Das Hybridpolymersystem 1 (EL6) wird mit Propylacetat im Verhältnis 1:2 (EL6 : Lösungsmittel) verdünnt. Dem verdünnten System werden 1 % Photostarter, bezogen auf EL6, zugegeben. Als Photostarter wird Irgacure® 907 (Ciba-Geigy) benutzt. Das verdünnte EL6 wird auf einen Silizium-Wafer, der vorher gereinigt und silanisiert wurde, mit einer Umdrehungsrate von 1500 U/min aufgeschleudert. Vor der Belichtung wird das Substrat 2 min bei 110 °C auf einer Heizplatte erwärmt und danach wieder auf Raumtemperatur abgekühlt. Die Belichtung wird an einem Maskaligner durchgeführt. Vor der Belichtung wird die Belichtungskammer 2 min lang mit Stickstoff gespült. Das Substrat wird mit einem Qucksilberlampenspektrum 30s belichtet. Die Intensität beträgt 20 mW/cm$^2$, gemessen bei einer Wellenlänge von 405 nm. Nach der Belichtung wird das Substrat wieder 2 min auf einer Heizplatte bei 150 °C erwärmt und auf Raumtemperatur abgekühlt. Wird während der Belichtung eine Maske verwendet, kann anschließend das organisch nicht vernetzte EL6 in einer Entwicklerlösung aus M-Pentanon und Isopropanol (1:1) 30 s lang entwickelt werden. Das Substrat wird schließlich drei Stunden bei 150°C in einem Ofen ausgeheizt.

Bei diesen Prozessparametern wird eine Schichtdicke von ca. 500 nm erreicht. Die Oberflächenenergie dieser Schicht kann nach der Methode von Owens mit Hilfe einer Kontaktwinkelmessung (mit Wasser und Ethylenglycol) zu ca. 30 N/mm$^2$ bestimmt werden.

1.3 Deposition kleiner Moleküle (Pentazen)

Das Ausgangsmaterial für die Halbleiterschicht ist ein feinkörniges Pulver aus kommerzieller Quelle, welches in einem mehrstufigen Sublimations- und Kondensationsprozess vorgereinigt wird. Das vorgereinigte Pulver wird in einem Tiegel, oder einer Knudsenzelle bis zur Sublimation erhitzt und die abdampfenden Moleküle kondensieren an der un- oder leicht beheizten Oberfläche des Substrates mit dem Hybridpolymersystem 1 (E16). Die RMS-Rauhigkeit von E16 beträgt 2,1nm. In einem genau geregelten Aufdampfvorgang werden dann nominell 50nm des Halbleiters sehr langsam mit einer Aufdampfrate von ca. 0,1-0,3nm/min aufgebracht. Die Substrattemperatur liegt bei 65°C, bei niedrigerer Temperatur (Raumtemperatur) sind die Kristallite etwas kleiner.

1.4 Charakterisierung der Schichten

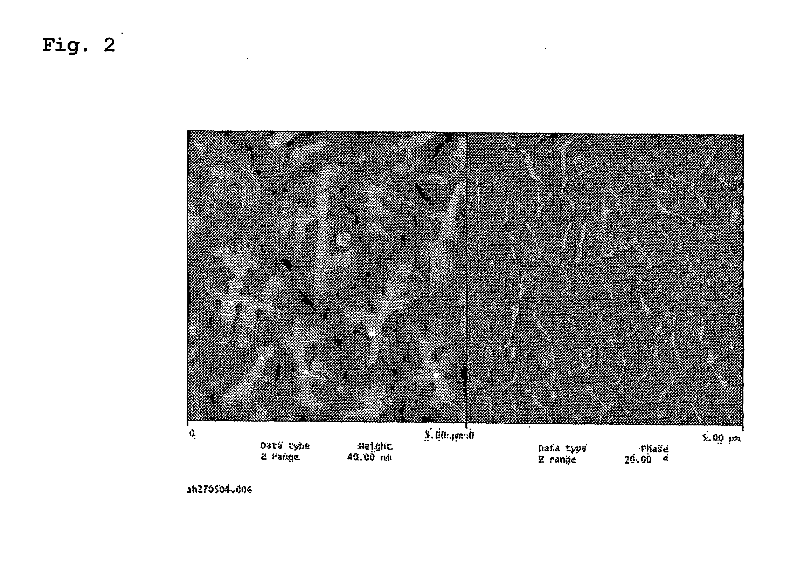

Wie bereits erwähnt, bestimmt die Art der Anordnung der Oligomermoleküle auf dem Substrat die strukturellen, morphologischen und elektrischen Eigenschaften des dünnen Halbleiterfilms. Die Morphologie der Pentazenschichten auf dem Hybridpolymersystem 1 wird mit einem Rasterkraftmikroskop untersucht, in Fig. 2 ist ein Beispiel für eine typische Variation der Topographie (links) und des Elastizitätsmoduls (rechts) dargestellt.

Im Höhenbild kann man deutlich inselartige, stark dentritische Strukturen erkennen. Diese können einzelnen Pentazenkristalliten zugeordnet werden, die Größe der Körner liegt zwischen 2 und 3 μm und ist gleichmäßig über das gesamte Substrat verteilt. Es wurden mehrere Aufnahmen pro Substrat gemacht, die sich bezüglich Korngröße und -form nur minimal voneinander unterscheiden. Die Form der Kristallite und ihre Größe ist typisch für hochkorreliertes Filmwachstum und für gut geordnete, polykristalline Schichten.

Genauere Aussagen zu der Struktur und der Kristallinität der Filme kann man über Pulverdiffraktometrie mit Röntgenstrahlen erhalten. Dabei werden die (001)-Reflexe der Pentazeneinkristallite gemessen (1 = 1,2,3,...bezeichnet die Ordnung der Röntgenhauptmaxima) und entsprechenden Netzebenenabständen zugeordnet. Je besser und homogener geordnet die polykristallinen Schichten bezüglich der Substratnormalen sind, umso höhere Ordnungen können beobachtet werden. Falls man Anteile verschiedener Pentazenpolymorphe hat, können diese anhand einer unterschiedlichen Lage der (001)-Reflexe differenziert werden, da ein anderer Wachstumswinkel der Moleküle sich in erster Linie in einer veränderten c-Achsenlänge der Elementarzelle und damit in einem veränderten Netzebenenabstand wiederspiegelt.

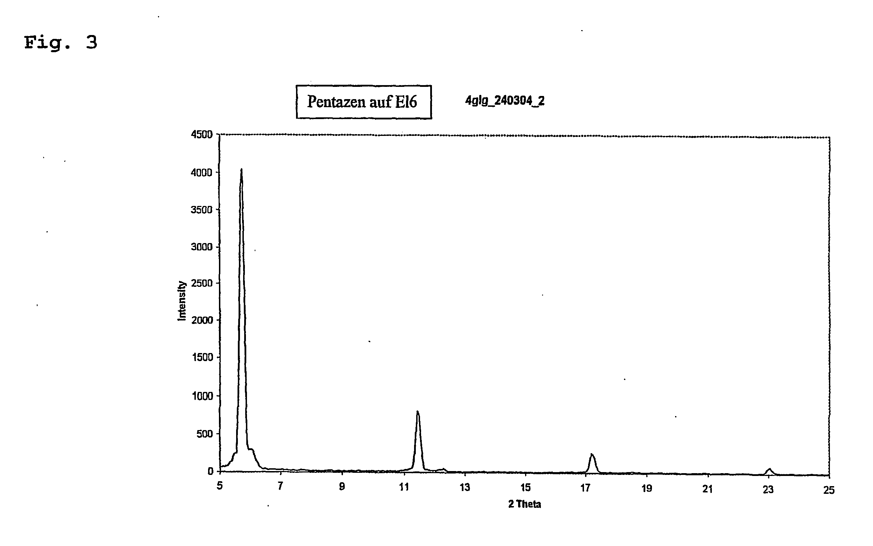

Das Pulverspektrum eines 50nm Pentazenfilms auf dem Hybridpolymersystem 1 (E16) zeigt hauptsächlich die Dünnfilmphase mit einem charakteristischen (001)-Reflex bei $2\Theta=5{,}7°$ (s. Fig. 3). (001)-Reflexe sind bis zur 4.Ordnung deutlich erkennbar, auch sind die Hauptmaxima hinreichend scharf und intensiv, so dass von einer senkrecht zur Oberfläche wohlgeordneten, wenn auch azimutal ungeordneten, d.h. polykristallinen Schicht auszugehen ist. Bis zur zweiten Ordnung beobachtet man auch einen sehr geringen Anteil (5%) der Volumenphase ($2\Theta=6{,}1°$).

1.5 Herstellung von TFTs und ihre elektrische Charakterisierung

Aus den mit E16 beschichteten Siliziumwafern und der kondensierten Pentazenschicht lässt sich relativ einfach ein Dünnfilmtransistor in Top-Contact Konfiguration herstellen (Fig. 1a), indem man Au selektiv über Schattenmasken durch Elektronenstrahl- oder thermisches Verdampfen aufbringt und so Source- und Drainelektroden herstellt. Als Gatelektrode dient der Wafer. Das Gatedielektrikum bildet E16.

Die Elektroden können auch unter der Pentazenschicht (Fig. 1b, Bottom-Contact) in einem photolithographischen oder anderen Strukturierungsverfahren aufgebracht werden und es können auch andere Kontaktmaterialien wie beispielsweise leitende Polymere (Polyanilin) verwendet werden. In weiterer Folge, besonders für die Integration verschiedener Bauelemente, ist auch eine Strukturierung der Gatelektrode notwendig. Auch der umgekehrte Aufbau bietet anwendungsspezifische Vorteile (Fig. 1c).

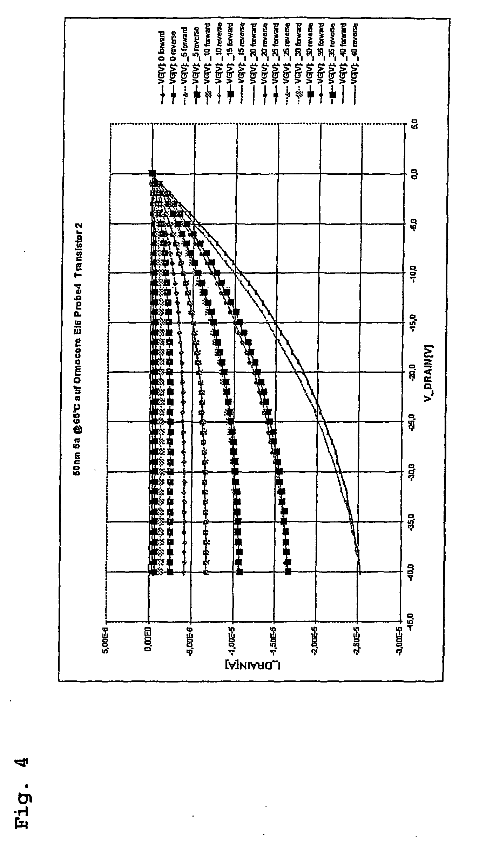

Die elektrische Charakterisierung der Transistoren mit E16 als Dielektrikum am Spitzenmessplatz durch einen Parameteranalyser zeigt einen ausgeprägten Feldeffekt in der Ausgangskennlinie, d.h. eine deutliche Steuerbarkeit des Sättigungsniveaus des Drainstroms mit der Gatespannung (Fig. 4). Der Kennlinienverlauf ist hinreichend gut, man beobachtet eine, für organische Dielektrika, zufriedenstellende Sättigung des Drainstroms, einen geringen Leckstrom (die Kennlinien schneiden sich alle bei $V_{DS}$=0V), der auf eine hinreichende Dichtheit des Dielektrikums schließen lässt und wenig Hysterese zwischen den Kurven bei Hochfahren (forward) und bei Herunterfahren (reverse) der Drainspannung. Allerdings muss einen relativ hohe positive Spannung angelegt werden, um alle Ladungsträger aus dem Kanal zu räumen.

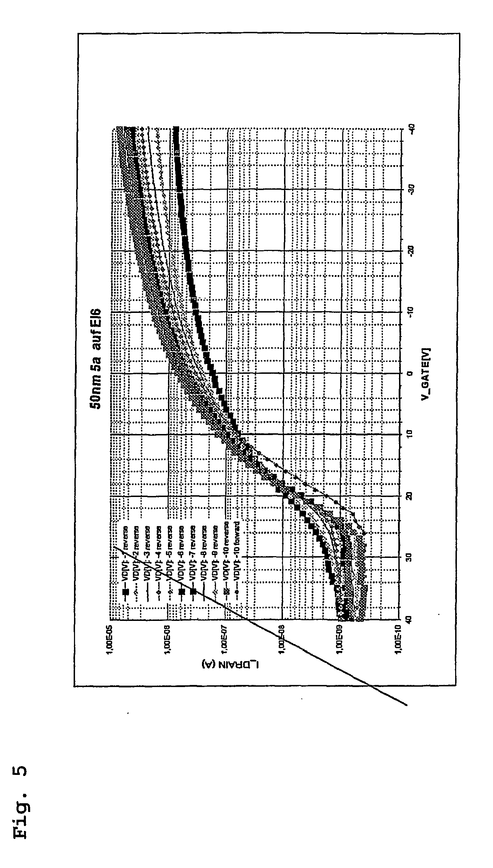

Fig. 5 zeigt die Transferkennlinie des selben Transistors im Linearbereich (kleine $V_{DS}$), hier beobachtet man einen Anstieg des Subthreshold Slopes ($\Delta I_D/\Delta I_G$) mit steigender Drainspannung, begleitet von einer Abnahme des Leckstroms, was auf ein sukzessives Auffüllen von Traps an der Grenzfläche mit beweglichen Ladungsträgern zurückzuführen ist. Ab $V_{DS}$=-7V ändert sich diese Steigung nicht mehr, dann sind die schwer entladbaren Traps gefüllt und spielen für die Ladungsträgerdynamik keine Rolle mehr. Außerdem erkennt man, dass die Spannung $V_0$, die benötigt wird um den Transistor in den Off-Zustand ($I_{off}$=1E-9) zu fahren, relativ hohe positive Werte von $V_0$=24V annimmt.

Der Transistor ist also normally-on. Das Verhältnis On- zu Off-Strom beträgt $10^4$-$10^5$. Zwischen Forward- und Reverse-Messung beträgt die Hysterese ca. 3V, was eine ebenso große Verschiebung in der Einsatzspannung bedeutet.

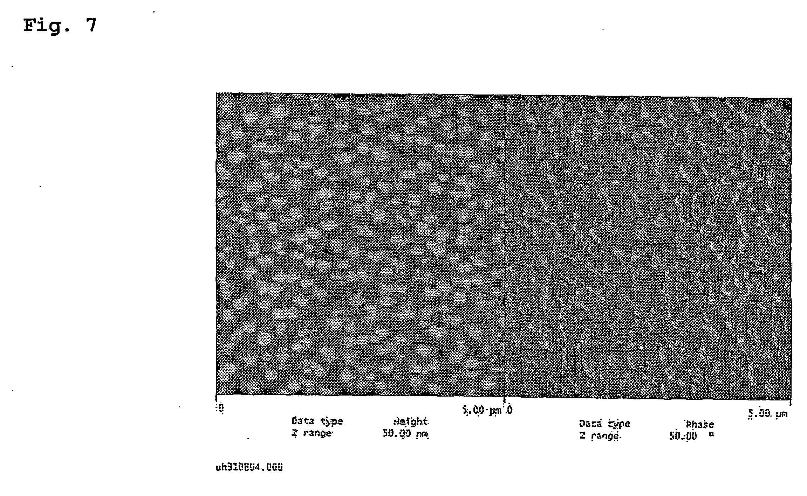

Aus der Transferkennlinie im Linearbereich kann nach $$g_m = \frac{\partial I_D}{\partial V_G} = \frac{W}{L} \cdot C_i \cdot \mu_{eff} \cdot V_D$$ die Transconductance $g_m$ ermittelt und daraus die Ladungsträgerbeweglichkeit $\mu_{eff}$ bestimmt werden. W bezeichnet die Weite, L die Länge des aktiven Kanals und $C_i$ die flächenspezifische Kapazität des Dielektrikums. In Fig. 7 ist die Abhängigkeit der Ladungsträgerbeweglichkeit von der Gatespannung dargestellt. Man erkennt einen für organische Dielektrika typischen linearen Anstieg der Beweglichkeit mit der Gatespannung und eine Art Sättigung bei $V_{GS}$>-25V, die durch eine Strombegrenzung auf Grund des Kontaktwiderstandes zurückzuführen ist. Die maximale, effektive Beweglichkeit liegt zwischen $0,2$ cm$^2$/Vs < $\mu_{eff}$ < $0,25$ cm$^2$/Vs. Ein verbessertes Engineering der Kontakte könnte die Sättigung von $\mu_{eff}$ verringern oder verhindern, so dass die zu erreichenden Stromniveaus bei $V_{GS}$>-25V deutlich ansteigen.

**Beispiel 2**

2.1 Harzsynthese und Charakteristika (EL20)

Die Herstellung von Hybridpolymersystem 2 (EL20) erfolgt nach folgendem Schema:

| | |
|---|---|
| 20 mol% | Diphenylsilandiol |
| 20 mol% | Dimethyldiethoxysilan |
| 1 mol/Si-O-Gruppe | Diethylcarbonat |
| 1 mol-% (bez. auf Silane) | NH$_4$F |
| 35 mol% | Epoxycyclohexylethyl-trimethoxysilan |
| 25 mol% | Memo NT |
| 50 %stöch. | H$_2$O (bez. auf Hydrolyse) |

In einem 1l Drei-Hals-Kolben, der mit einem Kühler, einem Thermometer und einem Tropftrichter ausgestattet ist, werden die ersten 4 Komponenten in oben stehender Reihenfolge eingewogen und 5 Tage bei Raumtemperatur gerührt. Der Ansatz ist klar bis opak. Die restlichen Komponenten werden zugewogen, der Ansatz ist zunächst weiß bis trüb und klärt sich innerhalb von 6 Stunden. Die gesamten Reaktionen werden bei Raumtemperatur durchgeführt. Nach 2d wird der Ansatz abrotiert (bis 13 mbar).

2.2 Substratherstellung (Technologie) und Charakteristika

Das Hybridpolymersystem 2 (EL20) wird mit Propylacetat im Verhältnis 1:1 (EL20 : Lösungsmittel) verdünnt. Dem verdünnten System werden 1 % Photostarter, bezogen auf EL20, zugegeben. Als Photostarter wird Irgacure® 369 (Ciba-Geigy) verwendet. Das verdünnte EL20-System wird auf einen Silizium-Wafer, der vorher gereinigt wurde, mit einer Umdrehungsrate von 3000 U/min aufgeschleudert. Die Belichtung wird an einem Maskaligner durchgeführt. Vor der Belichtung wird die Belichtungskammer 1 min lang mit Stickstoff gespült. Das Substrat wird mit einem Quecksilberlampenspektrum 30s belichtet. Die Intensität beträgt 20 mW/cm$^2$, gemessen bei einer Wellenlänge von 405 nm. Nach der Belichtung wird das Substrat wieder 2 min auf einer Heizplatte bei 110 °C erwärmt und auf Raumtemperatur abgekühlt. Wird während der Belichtung eine Maske verwendet, kann anschließend das organisch nicht vernetzte EL20-System 1 in einer Entwicklerlösung aus M-Pentanon und Isopropanol (1:1) 30 s lang entwickelt werden. Das Substrat wird schließlich drei Stunden bei 150°C in einem Ofen ausgeheizt.

Bei diesen Prozessparametern wird eine Schichtdicke von ca. 500 nm erreicht. Die Oberflächenenergie dieser Schicht kann nach der Methode von Owens mit Hilfe einer Kontaktwinkelmessung (mit Wasser und Ethylenglycol) zu ca. 29 N/mm$^2$ bestimmt werden.

2.3 Deposition kleiner Moleküle (Pentazen)

Das Ausgangsmaterial für die Halbleiterschicht ist ein feinkörniges Pulver aus kommerzieller Quelle, welches in einem mehrstufigen Sublimations- und Kondensationsprozess vorgereinigt wird. Das vorgereinigte Pulver wird in einem Tiegel, oder einer Knudsenzelle bis zur Sublimation erhitzt und die abdampfenden Moleküle kondensieren an der un- oder leicht beheizten Oberfläche des Substrates mit dem Hybridpolymersystem 2 (E120). Die rms-Rauhigkeit von E120 beträgt nur 0,84nm. Man hat es also mit einer nahezu atomar glatten Oberfläche zu tun. In einem genau geregelten Aufdampfvorgang (parallel zu E16) werden dann nominell 50nm des Halbleiters sehr langsam mit einer Aufdampfrate von ca. 0,1-0,3nm/min aufgebracht. Die Substrattemperatur liegt bei 65°C, bei niedrigerer Temperatur (Raumtemperatur) sind die Kristallite etwas kleiner.

2.4 Charakterisierung der Schichten

Die Rasterkraftmikroskopaufnahme von 50nm Pentazen auf E120 zeigt keine dentritischen, großen Kristallite, wie bei E16, sondern kleine, etwas eckige Körner und eine sehr große Nukleationsdichte (Fig. 7), obwohl die Rauhigkeit von E120 weit unter der von E16 liegt. Für das schlechtere Wachstum von Pentazen muss alleine die unterschiedliche Oberflächenchemie entsprechend einer unterschiedlichen Formulierung der Hybridpolymersysteme verantwortlich gemacht werden.

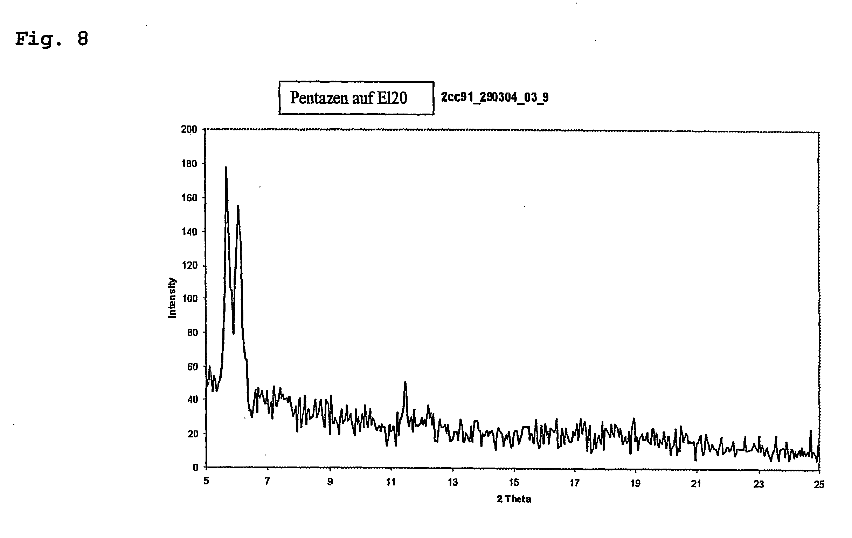

In dem Pulverspektrum (Fig. 8), das auch von diesem Pentazenfilm gemacht wurde, sieht man, dass der Volumenphasenanteil (2Θ=6,1°) im Vergleich zum Anteil der Dünnfilmphase deutlich ansteigt, wegen der geringeren Ordnung der Kristallite nur noch der (001)-Reflex beobachtet werden kann und die Halbwertsbreite der (001)-Reflexe abnimmt, was mit der verringerten Kristallitgröße zusammenhängt.

2.5 Herstellung von TFTs und ihre Charakterisierung

Aus den mit E120 beschichteten Siliziumwafern und der kondensierten Pentazenschicht lässt sich relativ einfach ein Dünnfilmtransistor in Top-Contact Konfiguration herstellen (Fig. 1a), indem man Au selektiv über Schattenmasken durch Elektronenstrahl- oder thermisches Verdampfen aufbringt und so Source- und Drainelektroden herstellt. Als Gatelektrode dient der Wafer. Das Gatedielektrikum bildet E120.

Die Elektroden können auch unter der Pentazenschicht (Fig. 1b, Bottom-Contact) in einem photolithographischen oder anderen Strukturierungsverfahren aufgebracht werden und es können auch andere Kontaktmaterialien wie beispielsweise leitende Polymere (Polyanilin) verwendet werden. In weiterer Folge, besonders für die Integration verschiedener Bauelemente, ist auch eine Strukturierung der Gatelektrode notwendig. Auch der umgekehrte Aufbau bietet anwendungsspezifische Vorteile (Fig. 1c).

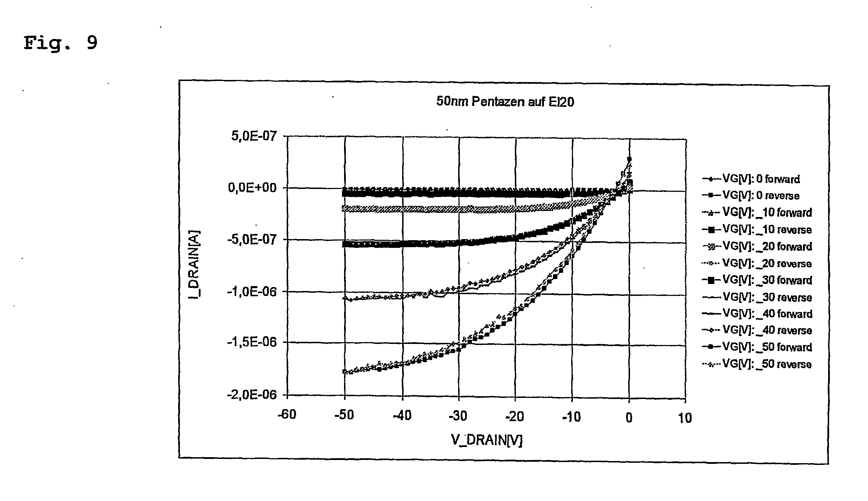

Die elektrische Charakterisierung der Transistoren mit E120 als Dielektrikum am Spitzenmessplatz durch einen Parameteranalyser zeigt einen deutlichen Feldeffekt in der Ausgangskennlinie (Fig. 9). Man beobachtet eine, für organische Dielektrika, zufriedenstellende Sättigung des Drainstroms, aber auch einen, im Vergleich zum Drainstrom, nicht zu vernachlässigenden Leckstrom über das Dielektrikum (die Kennlinien schneiden sich nicht bei $V_{DS}$=0V). Ebenso wie bei E16 ist die Hysterese zwischen den Kurven bei Hochfahren (forward) und bei Herunterfahren (reverse) der Drainspannung eher klein.

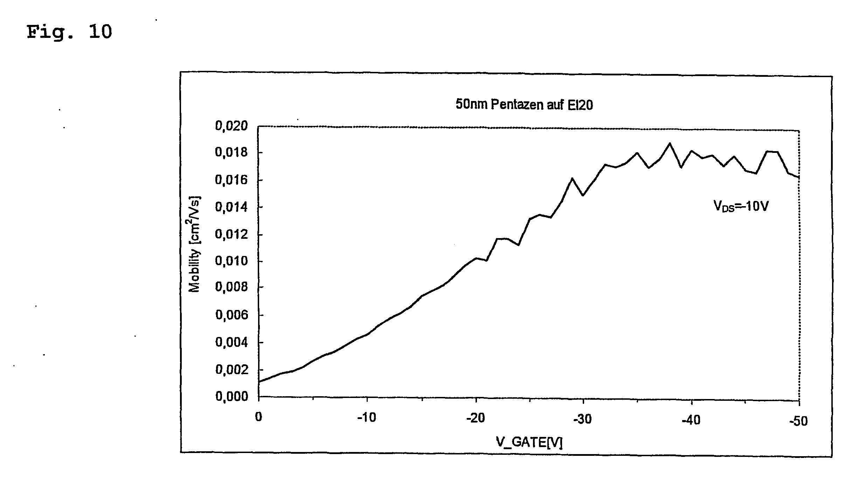

In Fig. 10 ist die Abhängigkeit der Ladungsträgerbeweglichkeit von der Gatespannung für diesen Transistor dargestellt. Die Beweglichkeit wurde gleich wie bei dem E16-Transistor über die Transconductance bestimmt. Auch für den E120-Transistor erkennt man den für organische Dielektrika typischen linearen Anstieg der Beweglichkeit mit der Gatespannung und eine Art Sättigung bei $V_{GS}$>-25V, die durch eine Strombegrenzung auf Grund des Kontaktwiderstandes zurückzuführen ist. Die maximale effektive Beweglichkeit ist allerdings um eine Größenordnung geringer ($\mu_{eff}$ = 0,02 cm$^2$/Vs) als bei Beispiel 1 (E16).

Wie der Vergleich der Transistoren auf E16 und E120 zeigt, scheint zwischen Korngröße, polykristallinem Ordnungsgrad und Ladungsträgerbeweglichkeit eine Korrelation zu bestehen. Je höher der Ordnungsgrad und je größer die Kristallite, desto höher ist auch die Beweglichkeit der Löcher und desto besser ist die Performance des Transistors. Auch der erhöhte Bulkphasenanteil könnte einen Beitrag zur Verringerung der Beweglichkeit leisten.

**Patentansprüche**

**1.** Verfahren zur Herstellung eines Halbleiterbauelementes mit einer Metall-Isolator-Struktur (MIS) enthaltend ein Substrat, eine Schicht aus einem organischen Halbleitermaterial und eine dielektrische Schicht als Isolator, bei dem das Substrat und die dielektrische Schicht aus einem organisch modifizierten Kieselsäure(hetero)polykondensat mit folgenden Schritten hergestellt werden:

(i) Vorkondensation von:

a) 1 bis 10 Mol-% von mindestens einer SiliciumVerbindung der Formel I :

$$MR_4 \qquad (I)$$

wobei
M ausgewählt ist aus der Gruppe Silicium, Zirkonium, Aluminium und Titan und R ein Halogen, Hydroxy, Alkoxy, Acyloxy oder ein Chelatligand ist;
b) 20 bis 94 Mol-% von mindestens einem organischen Silan der Formel II:

$$R''_m(YR''')_nSiX_{(4-m-n)} \qquad (II)$$

wobei

R'' Alkyl, Aryl, Alkylaryl, Arylalkyl ist,
R''' Alkylen, Alkenylen, Arylen, Alkylarylen, Arylalkylen, Alkenylarylen, Arylakenylen ist,

wobei R'' und R''' durch Sauerstoff, Schwefel oder -NH- unterbrochen sein können,

X Wasserstoff, Halogen, Hydroxy, Alkoxy, Acyloxy, -NR$_2$' ist, wobei R' gleich H oder Alkyl ist,
Y eine polymerisierbare Gruppe ist,
m eine ganze Zahl von 0 bis 2 ist,
n eine ganze Zahl von 1 bis 3 ist,
m+n von 1 bis 3 reichen und

c) 5 bis 30 Mol-% von mindestens einem organischen Silan der Formel III;

$$R''_pSiX_{4-p} \qquad (III)$$

wobei R' und X die obige Bedeutung besitzen und p gleich 1, 2 oder 3 ist, und gegebenenfalls
d) 0 bis 10 Mol-% von mindestens einem niedrigflüchtigen im Reaktionsmedium löslichen Metalloxid eines Elementes der Gruppen Ia bis Va oder Vb oder einer im Reaktionsmedium löslichen Verbindung von einem dieser Elemente, welche ein niedrigflüchtiges Oxid bilden; ohne externe Zugabe von Wasser, gegebenenfalls in Gegenwart eines organischen Lösungsmittels bei einer Temperatur zwischen 0 und 90 °C während eines Zeitraumes zwischen 0,5 und 48 Stunden und

(ii) Hydrolysekondensation des Vorkondensats aus Schritt (i) mit der stöchiometrischen Menge an Wasser, bei einer Temperatur zwischen 0 und 100 °C während eines Zeitraums zwischen 1 und 72 Stunden.

2. Verfahren nach Anspruch 1,
**dadurch gekennzeichnet, dass** das Substrat und/oder die dielektrische Schicht mit einer Schichtdicke von 1 nm bis 1 $\mu$m, insbesondere von 1 nm bis 100 nm, erzeugt werden.

3. Verfahren nach einem der vorhergehenden Ansprüche,
**dadurch gekennzeichnet, dass** das Substrat als eine Schicht ausgebildet ist, die auf einer zusätzlichen Trägerstruktur angeordnet wird.

4. Verfahren nach einem der vorhergehenden Ansprüche,
**dadurch gekennzeichnet, dass** die Trägerstruktur aus einem anorganisch-organischen Hybridpolymer gebildet wird.

5. verfahren nach einem der vorhergehenden Ansprüche,
**dadurch gekennzeichnet, dass** die Trägerstruktur ausgewählt ist aus der Gruppe bestehend aus Metallen, Halbleitern, Substraten mit oxidischen Oberflächen, Gläsern, Folien, printed circuit boards (PCB), Polymeren, Heterostrukturen, Papier, Textilien und/oder Verbunden hiervon.

6. Verfahren nach einem der vorhergehenden Ansprüche,
**dadurch gekennzeichnet, dass** das anorganisch-organische Hybridpolymer eine Permittivität $\varepsilon_r$ < 3 besitzt.

7. Verfahren nach einem der vorhergehenden Ansprüche,
**dadurch gekennzeichnet, dass** das anorganisch-organische Hybridpolymer eine Permittivität $\varepsilon_r$ > 4 besitzt.

8. Verfahren nach einem der vorhergehenden Ansprüche
**dadurch gekennzeichnet, dass** das anorganisch-organische Hybridpolymer eine Wasserdampfpermeationsrate (WVTR) von $10^{-3}$ bis 30 g/m$^2$d, insbesondere von 0,1 bis 3 g/m$^2$d, jeweils bezogen auf eine Schichtdicke von 100 $\mu$m, aufweist.

9. Verfahren nach einem der vorhergehenden Ansprüche,
**dadurch gekennzeichnet, dass** das anorganisch-organische Hybridpolymer eine Durchschlagsfestigkeit im Bereich von 50 bis 400 V/$\mu$m aufweist.

10. Verfahren nach einem der vorhergehenden Ansprüche,
**dadurch gekennzeichnet, dass** das anorganisch-organische Hybridpolymer halogenfrei ist.

11. Verfahren nach einem der vorhergehenden Ansprüche,
**dadurch gekennzeichnet, dass** das anorganisch-organische Hybridpolymer transparent ist.

12. Verfahren nach einem der vorhergehenden Ansprüche,
**dadurch gekennzeichnet, dass** das anorganisch-organische Hybridpolymer gegenüber in der Halbleiterelektronik verwendeten Chemikalien und Lösungsmitteln beständig ist.

13. Verfahren nach einem der vorhergehenden Ansprüche,
**dadurch gekennzeichnet, dass** das Halbleiterlement zusätzlich eine Source- und eine Drain-Elektrode sowie ein Gate-Elektrode aufweist.

14. Verfahren nach einem der vorhergehenden Ansprüche,
**dadurch gekennzeichnet, dass** das organische Halbleitermaterial ausgewählt ist aus der Gruppe bestehend aus Pentazen, Poly(3-Hexylthiophen) (P3HT), Poly(p-phenylenvinylen) (PPV), Polyamid (PA), Polyacrylamide (PAA) und Phthalocyaninen.

15. Verfahren nach einem der vorhergehenden Ansprüche,
**dadurch gekennzeichnet, dass** das anorganisch-organische Hybridpolymer durch flächige Auftragungsverfahren, insbesondere Spin-Coating, Dip-Coating, Rakeln oder Sprühen oder durch strukturierende Auftragungsverfahren, insbesondere Siebdruck, Tampondruck, Ink-Jet, Offset-Druck sowie Tief- und Hochdruck aufgebracht wird.

**16.** Verfahren nach einem der vorhergehenden Ansprüche,
**dadurch gekennzeichnet, dass** das anorganisch-organische Hybridpolymer durch strukturierende Verfahren, insbesondere Siebdruck, Tampondruck, Ink-Jet, Offset-Druck sowie Tief- und Hochdruck strukturierbar ist.

**Claims**

**1.** Method for producing a semiconductor component having a metal-insulator structure (MIS) which contains a substrate, a layer made of an organic semiconductor material and a dielectric layer as insulator,
wherein the substrate and the dielectric layer are produced from an organically modified silicic acid (hetero)polycondensate with the following steps:

i) precondensation of

a) 1 to 10% by mol of at least one silicon compound of formula I:

$$MR_4 \qquad (I)$$

M being selected from the group silicon, zirconium, aluminium and titanium and R being a halogen, hydroxy, alkoxy, acyloxy or a chelate ligand;
b) 20 to 94% by mol of at least one organic silane of formula II:

$$R''_m(YR''')_n SiX_{(4-m-n)} \qquad (II)$$

R'' being alkyl, aryl, alkylaryl, arylalkyl,
R''' being alkylene, alkenylene, arylene, alkylarylene, arylalkylene, alkenylarylene, arylalkenylene,
R'' and R''' being able to be interrupted by oxygen, sulphur or -NH-,
X being hydrogen, halogen, hydroxy, alkoxy, acyloxy, -NR$_2$', R' being equal to H or alkyl,
Y being a polymerisable group,
m being a whole number from 0 to 2,
n being a whole number from 1 to 3,
m+n extending from 1 to 3 and

c) 5 to 30% by mol of at least one organic silane of formula III

$$R''_p SiX_{4-p} \qquad (III)$$

R' and X having the above meaning and p being equal to 1, 2 or 3 and if necessary
d) 0 to 10% by mol of at least one low volatile metal oxide, soluble in the reaction medium, of an element of groups Ia to Va or Vb or of at least one compound, soluble in the reaction medium, of one of these elements which form a low volatile oxide;
without external addition of water, if necessary in the presence of an organic solvent at a temperature between 0 and 90°C during a time period between 0.5 and 48 hours and

(ii) hydrolysis condensation of the precondensate of step (i) with the stoichiometric quantity of water, at a temperature between 0 and 100°C during a time period between 1 and 72 hours.

**2.** Method according to claim 1,
**characterised in that** the substrate and/or the dielectric layer are formed with a layer thickness of 1 nm to 1 $\mu$m, in particular of 1 nm to 100 nm.

**3.** Method according to one of the preceding claims,
**characterised in that** the substrate is configured as a layer, the latter being disposed on an additional carrier structure.

**4.** Method according to one of the preceding claims,
**characterised in that** the carrier structure is formed from an inorganic-organic hybrid polymer.

**5.** Method according to one of the preceding claims,
**characterised in that** the carrier structure is selected from the group comprising metals, semiconductors, substrates with oxidic surfaces, glasses, films, printed circuit boards (PCB), polymers, heterostructures, paper, textiles and/or composites thereof.

**6.** Method according to one of the preceding claims,
**characterised in that** the inorganic-organic hybrid polymer has a permittivity $\varepsilon_r < 3$.

**7.** Method according to one of the preceding claims,
**characterised in that** the inorganic-organic hybrid polymer has a permittivity $\varepsilon_r > 4$.

**8.** Method according to one of the preceding claims,
**characterised in that** the inorganic-organic hybrid polymer has a water vapour transmission rate (WVTR) of $10^{-3}$ to 30 $g/m^2d$, in particular of 0.1 to 3 $g/m^2d$ respectively relative to a layer thickness of 100 $\mu$m.

**9.** Method according to one of the preceding claims,
**characterised in that** the inorganic-organic hybrid polymer preferably has a breakdown strength in the range of 50 to 400 V/$\mu$m.

**10.** Method according to one of the preceding claims,
**characterised in that** the inorganic-organic hybrid polymer is halogen-free.

**11.** Method according to one of the preceding claims,
**characterised in that** the inorganic-organic hybrid polymer is transparent.

**12.** Method according to one of the preceding claims,
**characterised in that** the inorganic-organic hybrid polymer is resistant to chemicals and solvents used in semiconductor electronics.

**13.** Method according to one of the preceding claims,
**characterised in that** the semiconductor component has in addition a source and a drain electrode and also a gate electrode.

**14.** Method according to one of the preceding claims,
**characterised in that** the organic semiconductor material is selected from the group comprising pentacene, poly (3-hexylthiophene) (P3HT), poly(p-phenylenevinylene) (PPV), polyamide (PA), polyacrylamide (PAA) and phthalocyanines.

**15.** Method according to one of the preceding claims,
**characterized in that** the inorganic-organic hybrid polymer is applied by planar application methods, in particular spin-coating, dip-coating, knife-coating or spraying, or by means of structuring application methods, in particular screen printing, tampon printing, ink-jet, offset printing and also gravure and letterpress printing.

**16.** Method according to one of the preceding claims,
**characterized in that** inorganic-organic hybrid polymer is applied by means of structuring application methods, in particular screen printing, tampon printing, ink-jet, offset printing and also gravure and letterpress printing.

**Revendications**

**1.** Procédé de fabrication d'un composant semi-conducteur à structure de métal-isolant (MIS), comprend un substrat, une couche de matériau semi-conducteur organique et une couche diélectrique comme isolant, dans lequel le substrat et la couche diélectrique sont fabriqués à partir d'un (hétéro)polycondensat d'acide silicique organiquement modifié selon les étapes suivantes :

(i) précondensation de :

a) 1 à 10 % en mole d'au moins un composé de silicium de formule I :

$$MR_4 \qquad (I)$$

dans laquelle :

M est choisi dans le groupe constitué du silicium, du zirconium, de l'aluminium et du titane et R est un halogène ou un groupement hydroxy, alcoxy, acyloxy ou encore un ligand chélatant ;

b) 20 à 94 % en mole d'au moins un silane organique de formule II :

$$R''_m(YR''')_n SiX_{(4-m-n)} \qquad (II)$$

dans laquelle :

R'' est un groupement alkyle, aryle, alkylaryle, arylalkyle,
R''' est un groupement alkylène, alcénylène, arylène, alkylarylène, arylalkylène, alcénylarylène, arylalcénylène,
R'' et R''' pouvant être interrompus par de l'oxygène, du soufre ou -NH-,
X représente l'hydrogène, un halogène, un groupement hydroxy, alcoxy, acyloxy, -NR$_2$', R' étant un H ou un alkyle,
Y représente un groupement polymérisable,
m est un nombre entier de 0 à 2,
n est un nombre entier de 1 à 3,
m+n varie entre 1 et 3, et

c) 5 à 30 % en mole d'au moins un silane organique de formule III :

$$R''_p SiX_{4-p} \qquad (III)$$

dans laquelle R' et X ont la signification mentionnée ci-dessus et
p est égal à 1, 2 ou 3 et, éventuellement,
d) 0 à 10 % en mole d'au moins un oxyde métallique de faible volatilité, soluble dans le milieu réactionnel, d'un élément des groupes Ia à Va ou Vb ou d'un composé soluble dans le milieu réactionnel d'un de ces éléments, qui forment un oxyde de faible volatilité ;
sans addition externe d'eau, éventuellement en présence d'un solvant organique à une température comprise entre 0 et 90 °C pendant une période de temps comprise entre 0,5 et 48 heures, et

(ii) condensation par hydrolyse du précondensat de l'étape (i) avec la quantité stoechiométrique d'eau, à une température comprise entre 0 et 100 °C pendant une période de temps comprise entre 1 et 72 heures.

**2.** Procédé selon la revendication 1,
**caractérisé en ce que** le substrat et/ou la couche diélectrique sont fabriqués avec une épaisseur de couche de 1 nm à 1 $\mu$m, en particulier de 1 nm à 100 nm.

**3.** Procédé selon l'une quelconque des revendications précédentes,
**caractérisé en ce que** le substrat se présente sous la forme d'une couche qui est disposée sur une structure de support supplémentaire.

**4.** Procédé selon l'une quelconque des revendications précédentes,
**caractérisé en ce que** la structure de support est formée d'un polymère hybride inorganique-organique.

**5.** Procédé selon l'une quelconque des revendications précédentes,
**caractérisé en ce que** la structure de support est choisie dans le groupe constitué de métaux, de semi-conducteurs, de substrats à surfaces oxydiques, de verres, de feuilles, de circuits imprimés (PCB), de polymères, d'hétérostructures, de papier, de textiles et/ou de composites de ceux-ci.

**6.** Procédé selon l'une quelconque des revendications précédentes,
**caractérisé en ce que** le polymère hybride inorganique-organique possède une permittivité $\varepsilon_r < 3$.

**7.** Procédé selon l'une quelconque des revendications précédentes,
**caractérisé en ce que** le polymère hybride inorganique-organique possède une permittivité $\varepsilon_r > 4$.

**8.** Procédé selon l'une quelconque des revendications précédentes,
**caractérisé en ce que** le polymère hybride inorganique-organique présente un taux de transmission de vapeur d'eau (WVTR) de $10^{-3}$ à 30 g/m$^2$d, en particulier de 0,1 à 3 g/m$^2$d, respectivement, rapporté à une épaisseur de couche de 100 $\mu$m.

**9.** Procédé selon l'une quelconque des revendications précédentes,
**caractérisé en ce que** le polymère hybride inorganique-organique présente une rigidité diélectrique dans la plage de 50 à 400 V/$\mu$m.

**10.** Procédé selon l'une quelconque des revendications précédentes,
**caractérisé en ce que** le polymère hybride inorganique-organique est exempt d'halogène.

**11.** Procédé selon l'une quelconque des revendications précédentes,
**caractérisé en ce que** le polymère hybride inorganique-organique est transparent.

**12.** Procédé selon l'une quelconque des revendications précédentes,
**caractérisé en ce que** le polymère hybride inorganique-organique résiste aux produits chimiques et aux solvants employés en électronique des semi-conducteurs.

**13.** Procédé selon l'une quelconque des revendications précédentes,
**caractérisé en ce que** le composant semi-conducteur comprend en outre une électrode de source et une électrode de drain, ainsi qu'une électrode de grille.

**14.** Procédé selon l'une quelconque des revendications précédentes,
**caractérisé en ce que** le matériau semi-conducteur organique est choisi dans le groupe constitué du pentacène, du poly(3-hexylthiophène) (P3HT), du poly(p-phénylènevinylène) (PPV), du polyamide (PA), du polyacrylamide (PAA) et des phtalocyanines.

**15.** Procédé selon l'une quelconque des revendications précédentes,
**caractérisé en ce que** le polymère hybride inorganique-organique est appliqué par des procédés d'application surfaciques, en particulier par dépôt à la tournette, dépôt par trempage, à la racle ou par pulvérisation, ou par des procédés d'application structurants, en particulier par sérigraphie, impression au tampon, jet d'encre, impression offset, ainsi que par héliogravure et impression en relief.

**16.** Procédé selon l'une quelconque des revendications précédentes,
**caractérisé en ce que** le polymère hybride inorganique-organique peut être structuré par des procédés structurants, en particulier par sérigraphie, impression au tampon, jet d'encre, impression offset, ainsi que par héliogravure et impression en relief.

Fig. 1

(a)

Source — Drain   Halbleiter

Gate

Substrat   Dielektrikum

(b)

Source — Halbleiter   Drain

Gate

Substrat   Dielektrikum

(c)

Source   Gate   Dielektrikum   Drain

Substrat   Halbleiter

Fig. 2

Fig. 3

Pentazen auf El6    4glg_240304_2

EP 1 803 173 B1

Fig. 4

Fig. 5

Fig. 6

Fig. 7

Fig. 8

EP 1 803 173 B1

Pentazen auf E120      2cc91_290304_03_9

Fig. 9

Fig. 10

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente

- WO 03038921 A1
- WO 02065557 A1
- EP 0537240 B1
- US 6617609 B2
- US 6187427 B
- WO 9325605 A
- EP 0644908 A

### In der Beschreibung aufgeführte Nicht-Patentliteratur

- Structural and Electrical Properties of Polymorphic Pentacene Thin Films. Proceedings of SPIE. **Stadlober, V. ; Satzinger, H. ; Maresch, D. ; Somitsch, A. ; Haase, H. ; Pichler, W. Rom ; G. Jakopic.** Organic Field Effect Transistors II. 2003, vol. 5217
- **U. Haas et al.** *Polytronic,* 2004, 219-223
- **J.A. Rogers ; Z. Bao ; A. Dodabalapur.** Organic smart pixels and complementary inverter circuits formed on plastic substrates by casting and rubber stamping. *IEEE Electron device lett.,* 2000, vol. 21 (3